# EUROPEAN PATENT APPLICATION

(11) **EP 4 741 738 A1**
(43) Date of publication of application: **13.05.2026**
(21) Application number: 24211208.4
(22) Date of filing: 06.11.2024
(51) Int. Cl.: F25B 49/02

(54) **METHOD OF CONTROLLING TEMPERATURE IN AN ENCLOSURE, AND AIR CONDITIONING SYSTEM FOR AN ENCLOSURE**

(71) Applicant: Thermo Onix Ltd, Winsford CW7 3GA (GB)
(72) Inventor: Josland, Graham, Winsford, CW7 3GA (GB); Johnson, Nigel, Winsford, CW7 3GA (GB); Harrop, John, Winsford, CW7 3GA (GB); Colloff, Paul, Winsford, CW7 3GA (GB)
(74) Representative: Boult Wade Tennant LLP

(57) **Abstract**

A method of controlling temperature in an enclosure is provided. The method comprises: passing a refrigerant through a circuit of an air conditioning system, the circuit comprising in order: a condenser; a capillary; an evaporator; and a compressor. The air conditioning system further comprises: an evaporator airflow generator for blowing air over the evaporator; and an enclosure heater for heating the air to be blown over the evaporator by the evaporator airflow generator. The method further comprises: switching on the enclosure heater when ambient temperature outside of the enclosure falls below a threshold temperature.

## Description

### Field

The present specification relates to a method of controlling the temperature of an enclosure. Particularly, the enclosure may be an enclosure for a mass spectrometer. This could especially be a mass spectrometer for use in an explosive environment. An air conditioning system for a mass spectrometer is also described.

### Background

Process Mass Spectrometers are typically installed in an enclosure (or shelter), and necessitate temperature regulation to ensure measurement stability and linearity. In order to keep the temperature stable, an air conditioning system is used to manage the temperature in the enclosure.

This air conditioning unit serves to cool the instrument when situated in hot environments. However, it encounters challenges in maintaining temperature control under low temperature conditions.

There is therefore a need for an improved method of controlling the temperature of an enclosure, and associated air conditioning system.

US 3 113 439 A discloses a heat pump adapted to heat or cool air from an enclosure and more particularly to a control arrangement for a heat pump having outdoor temperature compensating means adapted to provide biasing of the heat pump control means in anticipation of the heating and cooling requirements of the enclosure. There is a biasing heater and a thermistor connected such that when the outdoor temperature decreases, the thermistor resistance increases and the heating output of the heater decreases. This addresses the problem of the temperature sensed by a sensor in the enclosure lagging the actual outdoor temperature by compensating with the biasing heater.

### Summary

A method of controlling temperature in an enclosure is provided. The method comprising: passing a refrigerant through a circuit of an air conditioning system, the circuit comprising in order: a condenser; a capillary; an evaporator; and a compressor, wherein the air conditioning system further comprises: an evaporator airflow generator for blowing air over the evaporator; and an enclosure heater for heating the air to be blown over the evaporator by the evaporator airflow generator; and switching on the enclosure heater when ambient temperature outside of the enclosure falls below a threshold temperature.

This allows for effective temperature maintenance, even during low temperature conditions.

The evaporator airflow generator may specifically be an evaporator fan. This is a specific airflow generator which can be effective for this method.

The air conditioning system may further comprise a hot gas bypass valve configured to control a flow of refrigerant to pass directly from the compressor to the evaporator and bypass the condenser and capillary, and the method may further comprise the step of: opening and closing the hot gas bypass valve in regular intervals. This can be used to raise the temperature in the enclosure when needed.

The regular intervals may be between 30 and 60 seconds. Such regular intervals can effectively maintain a temperature in the enclosure.

The threshold temperature may be 25° or less, preferably 20° or less. Below such a temperature, the additional heating of the enclosure heater can be useful to maintain the temperature in the enclosure.

The method may further comprise the step of purging the enclosure of gas. This can allows the gas in the enclosure to be evacuated or removed.

The enclosure may be an enclosure for a mass spectrometer, optionally for use in explosive atmosphere. Mass spectrometers may need their temperature regulated for repeatable results. In an explosive atmosphere it can be even more important and/or more difficult to regulate the temperature of the enclosure.

An air conditioning system for an enclosure is provided. The air conditioning system comprising: a circuit for refrigerant, the circuit comprising in order: a condenser, a capillary; an evaporator; and a compressor; an evaporator airflow generator for blowing air over the evaporator; an enclosure heater for heating the air to be blown over the evaporator by the evaporator airflow generator; a controller configured to operate the enclosure heater in response to ambient temperature outside of the enclosure falling below a threshold temperature; and at least one sensor in communication with the controller, configured to monitor the air conditioning system.

This air conditioning system allows for effective temperature maintenance, even during low temperature conditions.

The evaporator airflow generator may specifically be an evaporator fan. This is a specific airflow generator which can be effective for this system.

The air conditioning system may further comprise a hot gas bypass valve configured to allow the refrigerant to pass directly from the compressor to the evaporator and bypass the condenser and capillary, wherein the controller is configured to open and close the hot gas bypass valve at regular intervals. This can be used to raise the temperature in the enclosure when needed.

The regular intervals may be between 30 and 60 seconds. Such regular intervals can effectively maintain a temperature in the enclosure.

The threshold temperature may be 25° or less, preferably 20° or less. Below such a temperature, the additional heating of the enclosure heater can be useful to maintain the temperature in the enclosure.

The air conditioning system may further comprise a high-pressure switch configured to detect failures of the condenser, wherein the controller is configured to switch off the compressor in response to the high-pressure switch detecting a failure of the condenser. Identifying this failure individually can be important to allow for precise control of the system.

The air conditioning system may further comprise a low-pressure switch configured to detect a loss of the refrigerant, wherein the controller is configured to switch off the compressor in response to the low-pressure switch detecting a loss of the refrigerant. Identifying this loss of refrigerant individually can be important to allow for precise control of the system.

The at least one sensor may include any of: an ambient temperature sensor; an enclosure temperature sensor; an evaporator airflow generator sensor; and/or an evaporator temperature sensor. These additional sensors can provide information relating to the air conditioning system and/or the enclosure to allow for effective temperature maintenance of the enclosure.

The evaporator airflow generator may specifically be an evaporator fan, and the evaporator airflow generator sensor may be an evaporator fan movement sensor.

The heater may comprise: one or more cartridge heaters installed within a conductive block; and one or more heat sinks. These are effective ways to provide heat to air being drawn/blown thereover.

One or more of the enclosure heater, compressor, and/or hot gas bypass valve, may be controlled by solid state relays. This allows the components to be switched off without moving parts, which can result in more reliable control of the air conditioning system.

The system may be for a mass spectrometer, and comprise: a processor configured to control operation of the mass spectrometer, the processor in communication with the controller. Mass spectrometers may need their temperature regulated for repeatable results.

The mass spectrometer may be for use in explosive atmosphere. In an explosive atmosphere it can be even more important and/or more difficult to regulate the temperature of the enclosure.

### Brief Description of the Drawings

The present specification makes reference, by way of example only, to the accompanying drawings in which:

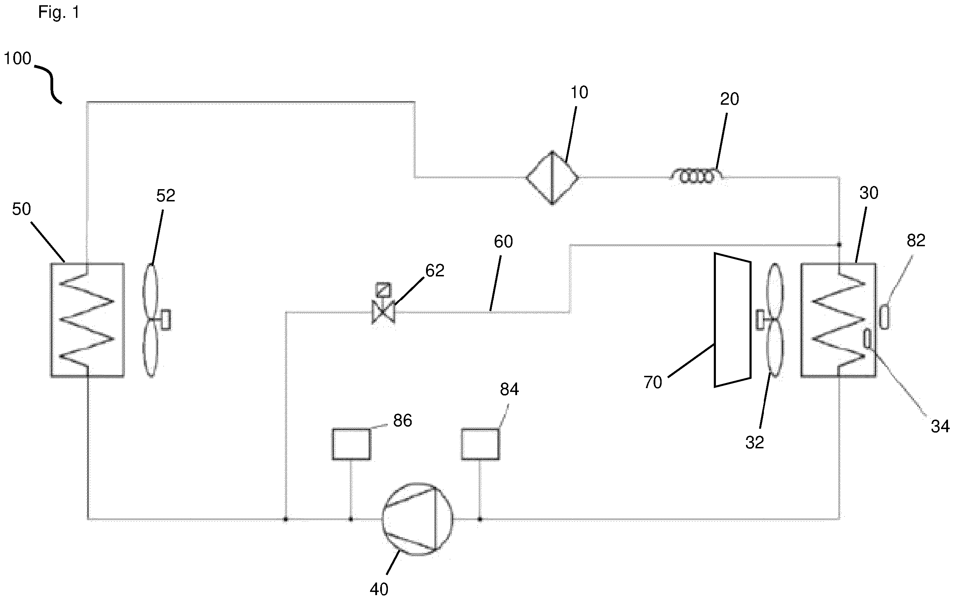

Figure 1 shows a schematic of an air conditioning system.

### Detailed Description

Figure 1 shows an air conditioning system 100 for controlling temperature in an enclosure. The air conditioning system 100 comprises a circuit which refrigerant flows around. This circuit may generally be a standard air conditioning system 100, with the modifications as discussed herein.

The air conditioning system 100 shown in Figure 1 comprises a compressor 40, a condenser 50, an evaporator 30 and a capillary 20. The refrigerant flows, in order, through the compressor 40, condenser 50, capillary 20, evaporator 30 and then back to the compressor 40.

The compressor 40 is configured to increase pressure of (i.e. pressurise) the refrigerant flowing therethrough. This can convert the refrigerant to a hot gas. The pressurised refrigerant is then received in the condenser 50.

Typically, the condenser 50 is arranged outside of the enclosure being cooled by the air conditioning system 100. Typically, the condenser 50 will have a condenser coil which the refrigerant flows through. In the condenser 50, the refrigerant cools down. For example, this could involve the refrigerant condensing from a gas into a liquid. A condenser fan, air amplifier, or other airflow generator 52 can be provided to increase airflow through the condenser 50, such as past the condenser coils. From the condenser 50, heat is dissipated into the ambient atmosphere.

The refrigerant then flows into the capillary 20, which is configured to reduce the pressure of the refrigerant flowing therethrough. Effectively, the capillary 20 is a tube which the refrigerant flows through. In certain cases, the capillary 20 could be replaced with an expansion valve. As the pressure of the refrigerant drops it cools. Some of the refrigerant may evaporate, resulting in a mixture of liquid and vapour.

The system of Figure 1 further comprises a filter 10 provided in the circuit between the condenser 50 and the capillary 20. However, this is not necessary. It could also be located at any other part of the circuit. The filter 10 is configured to remove contaminants from the refrigerant. For example, this could include dirt, metal particles or dust. In certain cases, the filter 10 can also act to remove moisture from the refrigerant.

From the capillary 20, the refrigerant flows to the evaporator 30. The evaporator 30 is configured to absorb heat from the enclosure to be cooled by the air conditioning system 100. The cooled refrigerant flows through the evaporator 30 to receive this heat. At least some of the refrigerant can evaporate from a liquid to a gas in the evaporator 30. The evaporator 30 may comprise evaporator coils such as shown in Figure 1, for the refrigerant to flow through. An evaporator airflow generator 32 is provided for blowing air from the enclosure over the evaporator 30. In the example of Figure 1, the evaporator airflow generator 32 is shown as an evaporator fan 32. The following specification will therefore refer to an evaporator fan 32, but any of the disclosure is equally applicable to any other type of evaporator airflow generator 32, such as an air amplifier.

Refrigerant then flows from the evaporator 30 back to the compressor 40 in order to start the cycle again.

Figure 1 shows an air conditioning system 100 where a hot gas bypass valve 62 is provided on a bypass line 60. However, this is not necessary for all systems. The bypass line 60 connects an output from the compressor 40 to an inlet of the evaporator 30. In other words, the bypass line 60 diverts the flow of refrigerant to bypass the condenser 50 and the capillary 20. The hot gas bypass valve 62 is arranged to selectively control a flow of refrigerant along the bypass line 60 to pass directly from the compressor 40 to the evaporator 30 (and thereby bypass the condenser 50 and capillary 20). The hot gas bypass valve 62 can selectively inhibit a flow of refrigerant through the bypass line 60. Because the capillary 20 is being bypassed, there is little work being done by the compressor 40 and hence little heat generated in the evaporator 30.

In use, the hot gas bypass valve 62 can be used to control a temperature of the enclosure cooled by the air conditioning system 100. The compressor 40 runs continuously, and the hot gas bypass valve 62 is opened and closed periodically. That is, the hot gas bypass valve 62 is opened for an opening period followed by being closed by a closed period, which is repeated. The time of the opening period and the closing period may be individually adjustable, and may vary between subsequent periods. For example, each may depend on the ambient temperature and/or a heat load of the enclosure.

In certain cases, this may be at regular intervals. These regular intervals may be between 30 seconds and 60 seconds.

The air conditioning system 100 further comprises an enclosure heater 70. This enclosure heater 70 being arranged to heat air which is blown over the evaporator 30. The enclosure heater 70 is arranged within the enclosure itself. The air conditioning system 100 is configured to switch on the enclosure heater 70 when the ambient temperature outside of the enclosure falls below a threshold. This threshold temperature may be any suitable value, such as 25° or less, or 20° or less. The threshold temperature may be a predetermined value which can be set by an operator of the air conditioning system 100. The enclosure heater 70 is provided adjacent to the evaporator fan 32, to optimise heat transfer.

A target temperature for the enclosure is set, which the air conditioning system 100 is designed to maintain. Typically there is an enclosure temperature sensor arranged to detect a temperature of the enclosure to compare it to this target temperature. When the temperature of the enclosure is above this target, the air conditioning system 100 operates as described above to cool the enclosure.

The target temperature may be any suitable temperature. For example, the target temperature may be around 28°C.

When the temperature of the enclosure is below this target temperature, the hot gas bypass valve 62 is opened. This typically leads to a rise in temperature of the enclosure, and the hot gas bypass valve 62 is then closed, to restart the cooling. However, if the ambient temperature is too low then the enclosure will not raise in temperature enough. This means that the hot gas bypass valve 62 remains open.

Prolonged operation with the hot gas bypass valve 62 open is not advisable, and so the air conditioning system 100 may be configured to automatically deactivate the compressor 40 if the hot gas bypass valve 62 remains open for more than a threshold time. Then, after a delay time the compressor 40 may be re-activated. If the temperature still remains too low, then this cycle will repeat itself.

In use, users sometimes attempt to address this problem by lowering the enclosure's target temperature and/or relocating the enclosure temperature sensor to a warmer area within the enclosure. While this approach works in certain scenarios, it carries the risk of insufficient cooling if the ambient temperature reaches the upper limit of the allowed range - for example during the summer.

Therefore, to address this the enclosure heater 70 is switched on when the ambient temperature is below the threshold temperature. This acts to heat up the temperature in the enclosure, thereby breaking the cycle noted above. As a result, the air conditioning system 100 effectively controls the temperature of the enclosure in a wider ambient temperature range. For example, the ambient temperature operating range for the air conditioning system 100 may be 12°C to 40°C.

The air conditioning system 100 may comprise a controller, which is configured to control the operation of one or more of the components thereof. For example, the controller may be configured to operate the enclosure heater 70 such as discussed above.

The air conditioning system 100 may further comprise one or more sensors configured to monitor the air conditioning system 100. For example, Figure 1 shows a high-pressure switch 86 (or high-pressure sensor). This high-pressure switch 86 is configured to detect failures of the condenser 50. In which case, the controller is then configured to switch off the compressor 40. Such failures of the condenser 50 may be caused, for example, by the ambient air temperature being too high or there being insufficient air flow over the condenser 50. The controller may switch on the compressor 40 once the ambient temperature has decreased, to restart the air conditioning system 100. Figure 1 shows this high-pressure switch 86 arranged in the circuit between the compressor 40 and condenser 50. Of course, any other suitable position for the high-pressure switch 86 may be used. The high-pressure switch 86 is in communication with the controller.

Additionally, or alternatively, the air conditioning system may comprise a low-pressure switch 84 (or low-pressure sensor). Figure 1 shows this low-pressure switch 84 arranged in the circuit between the evaporator 40 and the compressor 40. Of course, any other suitable position for the low-pressure switch 84 may be used. The low-pressure switch 84 is configured to detect a loss of refrigerant in the air conditioning system 100. Typically, this may be due to a leak in the circuit. As a result, the air conditioning system 100 may not be switched back on until this leak is rectified. The low-pressure switch 86 is in communication with the controller.

The low-pressure switch 84 and high-pressure switch 86 (when both are present) may be independently in communication with the controller. That is, the two failure modes can be independently monitored.

The air conditioning system 100 can additionally or alternatively comprise one or more additional sensors. This could include, for example, one or more of: an ambient temperature sensor; an enclosure temperature sensor 82; an evaporator airflow generator sensor configured to monitor the evaporator airflow generator 32 (for example, this could be an evaporator fan movement sensor); and/or an evaporator temperature sensor 34. Each sensor may be independently in communication with the controller.

The ambient temperature sensor is configured to measure an ambient temperature - i.e. a temperature outside of the enclosure.

The enclosure temperature sensor 82 is configured to measure a temperature inside of the enclosure. Figure 1 shows this enclosure temperature sensor 82 adjacent to the evaporator 30, but any suitably position inside the enclosure may be used. This enclosure temperature sensor 82 may be repositionable within the enclosure, so that a suitable location can be used.

As noted above, the evaporator airflow generator sensor may be an evaporator fan movement sensor, configured to monitor the evaporator fan 32, when the evaporator airflow generator 32 is an evaporator fan 32. This evaporator fan movement sensor could detect for example information on the movement of the evaporator fan 32. For example, a speed of the fan, and/or whether the fan is fluctuating in speed. This sensor can detect failure of the evaporator fan 32.

For example this could be an optical sensor. The evaporator fan 32 includes a plurality of fan blades which rotate to generate airflow. A reflective surface material may be affixed to one or more of the fan blades (or indeed one or more of the fan blades may be made from a reflective surface material). The optical sensor would emit light pulses, which are reflected by the reflective surface material. The reflected light pulses can then be sensed in order to detect information on the movement of the evaporator fan 32.

Of course, any other type of evaporator airflow generator sensor may be used to detect operating parameters or characteristics of the evaporator airflow generator 32, such as of an evaporator fan 32.

The evaporator temperature sensor 34 is configured to measure a temperature inside the evaporator 30. This specifically may be used to detect that the temperature in the evaporator 30 is too low, which could result in ice formation. In response to the temperature in the evaporator 30 being too low (i.e. below a predetermined threshold), the compressor 40 may be switched off - for example by the controller.

The air conditioning system 100 may comprise one or more solid state relays. That is, electronic switching device that uses electronic components to switch electrical loads on and off without the need for any moving parts, as opposed to a mechanical relay. One or more of the enclosure heater 70, compressor 40, and/or hot gas bypass valve 62 may be controlled by such solid state relays. That is, there may be a solid state relay arranged to selectively turn off and on the respective device. For example, there may be one or more of: a heater relay, a compressor relay, and/or a bypass relay. Each relay may be independently controllable.

The air conditioning system 100 may comprise one or more heater sensors arranged to detect an operation temperature of the enclosure heater 70. For example, this could include one or more thermal snap switches. These heater sensors can indicate that the temperature of the enclosure heater 70 is too high. For example, this could be due to a fault with the enclosure heater 70 or with the evaporator fan 32.

The enclosure heater 70 may comprise one or more cartridge heaters. Typically, this is a tube-shaped (e.g. cylindrical) heating element which has a heating element arranged therein. For example, this could be a resistive wire which converts electrical energy to heat when current flows therethrough.

Each cartridge heater may be installed within a conductive block. For example, this could be an aluminium block. The conductive block may have one or more recesses for receiving each cartridge heater.

The enclosure heater 70 may further comprise one or more heat sinks. These heat sinks may be integral or unitary with the conductive block, or may be separate thereto. Each heat sink may comprise one or more fins which conduct heat. Airflow past the fins then dissipates heat from the enclosure heater 70.

The air conditioning system 100 may comprise a display, configured to display characteristic information of the air conditioning system 100. This could include the temperature readings from any of the temperature sensors discussed herein, as well as the outputs of any of the other sensors. This display can be arranged external to the enclosure (or at least may be viewable external from the enclosure - such as via a window). The air conditioning system 100 may be configured to transmit this characteristic information to a remote device.

The air conditioning system 100 may be for use with a mass spectrometer. That is, the mass spectrometer may be arranged within the enclosure which is having its temperature controlled by the air conditioning system 100. This could specifically be used for a mass spectrometer which is used in an explosive atmosphere.

It is typical to install mass spectrometers in a temperature-controlled enclosure as this helps ensure measurement stability and linearity.

The system 100 further comprises a processor which is configured to control operation of the mass spectrometer. This processor being in communication with the controller to allow co-ordination of the control of the mass spectrometer and the control of the air conditioning system 100.

A corresponding method is also provided, for controlling temperature in an enclosure. This method can use the air conditioning system 100 as disclosed herein, including any modifications disclosed. Alternatively, any other suitable air conditioning system 100 may be used. The general method is discussed below, and any modifications discussed herein in relation to the air conditioning system 100 are equally applicable to this method.

The method comprises: passing a refrigerant through a circuit of an air conditioning system 100. The circuit comprises in order: a condenser 50; a capillary 20; an evaporator 30; and a compressor 40. That is, the refrigerant flows from the condenser 50 to the capillary 20 to the evaporator 30 to the compressor 40 and then back to the condenser 50.

The air conditioning system 100 of the method further comprises: an evaporator fan 32 for blowing air over the evaporator 30; and an enclosure heater 70 for heating the air to be blown over the evaporator 30 by the evaporator fan 32.

The method thus comprises: switching on the enclosure heater 70 when ambient temperature outside of the enclosure falls below a threshold temperature. This is discussed in detail above.

The method may additionally include the step of purging the enclosure of gas. This can particularly be relevant for cases where the enclosure is filled with or surrounded by an explosive atmosphere such as discussed above. The enclosure heater 70 is located in the purged enclosure.

In this sense, an improved method of controlling temperature in an enclosure and air conditioning system for an enclosure is provided.

## Claims

1. A method of controlling temperature in an enclosure, comprising:
passing a refrigerant through a circuit of an air conditioning system, the circuit comprising in order: a condenser; a capillary; an evaporator; and a compressor, wherein the air conditioning system further comprises:
an evaporator airflow generator for blowing air over the evaporator; and
an enclosure heater for heating the air to be blown over the evaporator by the evaporator airflow generator; and
switching on the enclosure heater when ambient temperature outside of the enclosure falls below a threshold temperature.

2. The method of claim 1, wherein the air conditioning system further comprises a hot gas bypass valve configured to control a flow of refrigerant to pass directly from the compressor to the evaporator and bypass the condenser and capillary, and the method further comprises the step of:
opening and closing the hot gas bypass valve in regular intervals.

3. The method of claim 2, wherein the regular intervals are between 30 and 60 seconds.

4. The method of any preceding claim, wherein the threshold temperature is 25° or less, preferably 20° or less.

5. The method of any preceding claim, further comprising the step of purging the enclosure of gas.

6. The method of any preceding claim, wherein the enclosure is an enclosure for a mass spectrometer, optionally for use in explosive atmosphere.

7. An air conditioning system for an enclosure, comprising:
a circuit for refrigerant, the circuit comprising in order: a condenser, a capillary; an evaporator; and a compressor;
an evaporator airflow generator for blowing air over the evaporator;
an enclosure heater for heating the air to be blown over the evaporator by the evaporator airflow generator;
a controller configured to operate the enclosure heater in response to ambient temperature outside of the enclosure falling below a threshold temperature; and
at least one sensor in communication with the controller, configured to monitor the air conditioning system.

8. The air conditioning system of claim 7, further comprising a hot gas bypass valve configured to allow the refrigerant to pass directly from the compressor to the evaporator and bypass the condenser and capillary, wherein the controller is configured to open and close the hot gas bypass valve at regular intervals,
optionally the regular intervals are between 30 and 60 seconds.

9. The air conditioning system of any of claims 7 to 8, wherein the threshold temperature is 25° or less, preferably 20° or less.

10. The air conditioning system of any of claims 7 to 9, further comprising a high-pressure switch configured to detect failures of the condenser, wherein the controller is configured to switch off the compressor in response to the high-pressure switch detecting a failure of the condenser.

11. The air conditioning system of any of claims 7 to 10, further comprising a low-pressure switch configured to detect a loss of the refrigerant, wherein the controller is configured to switch off the compressor in response to the low-pressure switch detecting a loss of the refrigerant.

12. The air conditioning system of any of claims 7 to 11, wherein the at least one sensor includes any of:
an ambient temperature sensor;
an enclosure temperature sensor;
an evaporator airflow generator sensor; and/or
an evaporator temperature sensor.

13. The air conditioning system of any of claims 7 to 12, wherein the heater comprises:
one or more cartridge heaters installed within a conductive block; and
one or more heat sinks.

14. The air conditioning system of any of claims 7 to 13, wherein one or more of the enclosure heater, compressor, and/or hot gas bypass valve, are controlled by solid state relays.

15. The air conditioning system of any of claims 7 to 14, wherein the system is for a mass spectrometer, and comprises:
a processor configured to control operation of the mass spectrometer, the processor in communication with the controller,
optionally the mass spectrometer is for use in explosive atmosphere.
